# EUROPEAN PATENT APPLICATION

(11) **EP 4 672 919 A1**
(43) Date of publication of application: **31.12.2025**
(21) Application number: 25185363.6
(22) Date of filing: 26.06.2025
(51) Int. Cl.: H10D 89/60, H02H 9/04

(54) **APPARATUS FOR PROTECTING ELECTRICAL OVER STRESS AND METHOD OF CONTROLLING THE APPARATUS**

(30) Priority: 27.06.2024 KR 20240084826; 23.08.2024 KR 20240113583
(71) Applicant: LX Semicon Co., Ltd., Daejeon 34027 (KR)
(72) Inventor: KONG, Min Chul, 34027 Daejeon (KR); KIM, Ho Seong, 34027 Daejeon (KR); LEE, Jae Hyun, 34027 Daejeon (KR)
(74) Representative: Goddar, Heinz J.

(57) **Abstract**

An apparatus for protecting electrical over stress (EOS) includes a discharge module configured to discharge EOS when a predetermined threshold voltage is sensed and a controller configured to control the discharge module, wherein the controller includes at least one sensing module configured to sense the predetermined threshold voltage and a feedback module configured to increase a response time of the discharge module when sensing the predetermined threshold voltage.

## Description

### CROSS-REFERENCE TO RELATED APPLICATIONS

This application claims the benefit of the Korean Patent Application No. 10-2024-0084826 AND 10-2024-0113583, which is hereby incorporated by reference as if fully set forth herein.

### BACKGROUND

### Field of the Invention

The present disclosure directly or indirectly relates to technology for protecting electrical over stress (EOS). For example, the present disclosure may be applied to a display driver integrated circuit (DDI) product and the like, but is not limited thereto.

### Discussion of the Related Art

Electrical over stress (EOS) causes a breakdown phenomenon due to an electromagnetic signal and an overvoltage and is a defective cause of a main element.

In integrated circuits (ICs), as a silicon process advances, an area of an internal transistor has been progressively reduced, and thus, semiconductors have been very sensitive to EOS and electro-static discharge (ESD). ESD is a kind of EOS and denotes a phenomenon where charge transfer occurs instantaneously before or just before an object electrified by contact/friction/induction contacts another object.

EOS is one of important causes of defects in semiconductor product groups, and due to a defect, the short circuit of a connector, the disconnection of a metal layer, or the gate breakdown of an oxide layer may occur.

Particularly, because a DDI process is progressively subdivided into 40 nm, 28 nm, and 22 nm recently, technology for improving ESD and EOS is more desperately required in industry.

### SUMMARY

Embodiments of the present disclosure are for solving the problem described above and are for minimizing an electrical over stress (EOS) phenomenon by using a positive feedback circuit or the like.

To accomplish the object described above, an apparatus for protecting electrical over stress (EOS) according to an embodiment of the present disclosure includes a discharge module configured to discharge EOS when a predetermined threshold voltage is sensed and a controller configured to control the discharge module. Here, the controller includes at least one sensing module configured to sense the predetermined threshold voltage and a feedback module configured to increase a response time of the discharge module when sensing the predetermined threshold voltage.

Moreover, the discharge module and the controller may be connected to a specific gate.

Moreover, the feedback module may be configured with a pair of at least one P-channel metal-oxide-semiconductor (PMOS) transistor and at least one N-channel metal-oxide-semiconductor (NMOS) transistor disposed near the specific gate. Also, the feedback module may amplify a voltage input to the NMOS transistor included in the discharge module.

Moreover, the controller may be disposed on, for example, a side surface of a chip, and the discharge module may be split and disposed on, for example, a lower surface of the chip.

Moreover, after the EOS is discharged, when less than the predetermined threshold voltage is formed, an operation of the feedback module may be deactivated.

A method for controlling an apparatus for protecting electrical over stress (EOS), according to an embodiment of the present disclosure, include a step of sensing a predetermined threshold voltage by using at least one sensing module, a feedback step of increasing a response time of a discharge module when sensing the predetermined threshold voltage, and a step of discharging EOS, based on the response time. The method may comprise any one, some or all of the features disclosed herein with reference to the apparatus, unless indicated otherwise or technically inappropriate. Also, the apparatus disclosed herein may comprise any one, some or all of the features disclosed herein with reference to the method, unless indicated otherwise or technically inappropriate.

According to an embodiment of the present disclosure, in terms of a circuit operation, there may be a technical effect for solving a problem where a product is broken down because a discharge transistor is slowed in a conventional circuit for protecting EOS.

Furthermore, according to another embodiment of the present disclosure, in terms of an arrangement view, a discharge module and a controller among circuits for protecting EOS may be divisionally arranged, and thus, a technical effect for removing a defect caused by a rail resistor may be realized.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure.
FIG. 1 illustrates an EOS protection circuit according to the related art;
FIG. 2 is a graph illustrating variations of a current and a voltage based on the EOS protection circuit illustrated in FIG. 1;
FIG. 3 is a block diagram schematically illustrating an EOS protection apparatus according to an embodiment of the present disclosure;
FIG. 4 is a circuit diagram illustrating the block diagram of FIG. 3 in more detail;
FIG. 5 illustrates an example of a case where an EOS protection circuit according to an embodiment of the present disclosure is disposed in an entire chip;
FIG. 6 illustrates another example of a case where an EOS protection circuit according to an embodiment of the present disclosure is disposed in an entire chip;
FIG. 7 is a circuit diagram illustrating the block diagram of FIG. 6 in more detail;
FIG. 8 is a graph illustrating variations of a current and a voltage based on an EOS protection circuit according to an embodiment of the present disclosure;
FIG. 9 is a graph of an experiment result for describing a comparison of the related art and an embodiment of the present disclosure;
FIG. 10 is a flowchart illustrating a method of controlling an EOS protection apparatus according to an embodiment of the present disclosure;
FIG. 11 illustrates operations of elements in a time sequence in the circuit diagram illustrated in FIG. 4;
FIGs. 12 to 14 illustrate another embodiment for implementing a feedback module illustrated in FIG. 4; and
FIG. 15 illustrates another embodiment for implementing a sensing module illustrated in FIG. 4.

### DETAILED DESCRIPTION OF THE DISCLOSURE

Reference will now be made in detail to the exemplary embodiments of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Furthermore, the present disclosure is only defined by scopes of claims.

Like reference numerals refer to like elements throughout. Throughout this specification, the same elements are denoted by the same reference numerals. In description below, detailed descriptions of elements and functions known in those skilled in the art and a case which is irrelevant to an essential element of the present disclosure may be omitted.

When 'comprise', 'have', 'consist of, 'constitute', or 'include' described herein is used, unless 'only ~' is used, another part may be added. When an element is described in the singular form, this may include the plural number unless explicitly described.

In construing an element included in various embodiments of the present disclosure, the element is construed to include an error range even without separate explicit description.

In describing various embodiments of the present disclosure, the terms 'first ~' and 'second ~' may be used for describing various elements, but the terms are merely used for distinguishing like or similar elements from each other. Therefore, in the present disclosure, unless separately described, an element modified by 'first ~' may be the same as an element modified by 'second ~' in the technical idea of the present disclosure.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various embodiments of the present disclosure may be partially or overall coupled to or combined with each other and may be variously inter-operated with each other and driven technically as those skilled in the art can sufficiently understand. The embodiments of the present disclosure may be carried out independently of each other, or may be carried out together in co-dependent relationship.

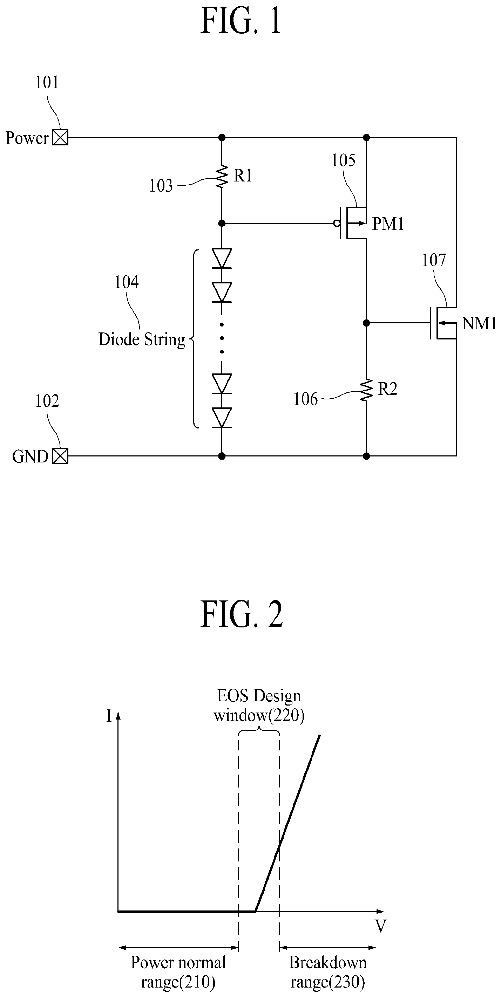

FIG. 1 illustrates an electrical over stress (EOS) protection circuit according to the related art. For example, the EOS protection circuit may be applied to a small display driver integrated circuit (DDI) product, but is not limited thereto.

As illustrated in FIG. 1, according to the related art, a diode string 104 for sensing a voltage level of a power 101 is applied, and a transistor (NM1) 107 for EOS discharge is included therein.

Moreover, the EOS protection circuit according to the related art is configured with a PM1 105 which is a transistor for driving the transistor (NM1) 107 for EOS discharge, a first resistor (R1) 103, and a second resistor (R2) 106. An NM of the present disclosure and the drawings may denote, for example, an N-channel metal-oxide-semiconductor (NMOS), and PM may denote, for example, a P-channel metal-oxide-semiconductor (PMOS).

An operation of a corresponding circuit illustrated in FIG. 1 will be described below in more detail.

First, a case where a voltage of a power is within a normal range may be described.

When the voltage level of the power 101 is not exceed a threshold voltage of the diode string 104, a current flowing in the diode string 104 may be very low. Therefore, voltage drop caused by the first resistor (R1) 103 may not occur, and thus, the transistor (PM1) 105 may maintain an off state, and the transistor (NM1) 107 connected thereto may be in an off state.

On the other hand, a case where a surge of a voltage of a power occurs (a case where an abnormal waveform having high energy occurs instantaneously) will be described below.

When the voltage level of the power 101 is higher than the threshold voltage of the diode string 104, a current may occur in the diode string 104.

Voltage drop may occur in the first resistor (R1) 103 due to a corresponding current, and the transistor (PM1) 105 may be put in an on state.

A gate-source voltage difference VGS may be formed in the transistor (NM1) 107 by a current of the transistor (PM1) 105 and the second resistor (R2) 106 and may be put in an on state, and thus, EOS may be discharged.

Moreover, a problem which occurs due to the EOS protection circuit according to the related art will be described below with reference to FIG. 2.

FIG. 2 is a graph illustrating variations of a current and a voltage based on the EOS protection circuit illustrated in FIG. 1.

In the EOS protection circuit of the related art illustrated in FIG. 1, a condition for fully turning on the transistor (NM1) 107 may be possible when a voltage difference between the power 101 and a ground 102 is sufficiently large.

The VGS of the transistor (NM1) 107 may be formed by a current of the transistor (PM1) 105, and thus, in order to allow a high current to flow in the transistor (PM1) 105, it should be designed that a voltage difference between the power 101 and the ground 102 increases, and a higher current flows in the diode string 104.

However, as illustrated in FIG. 2, a product where an EOS design window 220 is narrow may be impossible to use an operation process of a circuit of the related art described above.

For example, as illustrated in FIG. 2, when a normal voltage range 210 is 10 V, and a breakdown voltage range 230 is 11.5 V, an EOS discharge transistor should be fully turned on in a narrow interval (11.5V-10V=1.5V), but this may be impossible to implement, based on the related art.

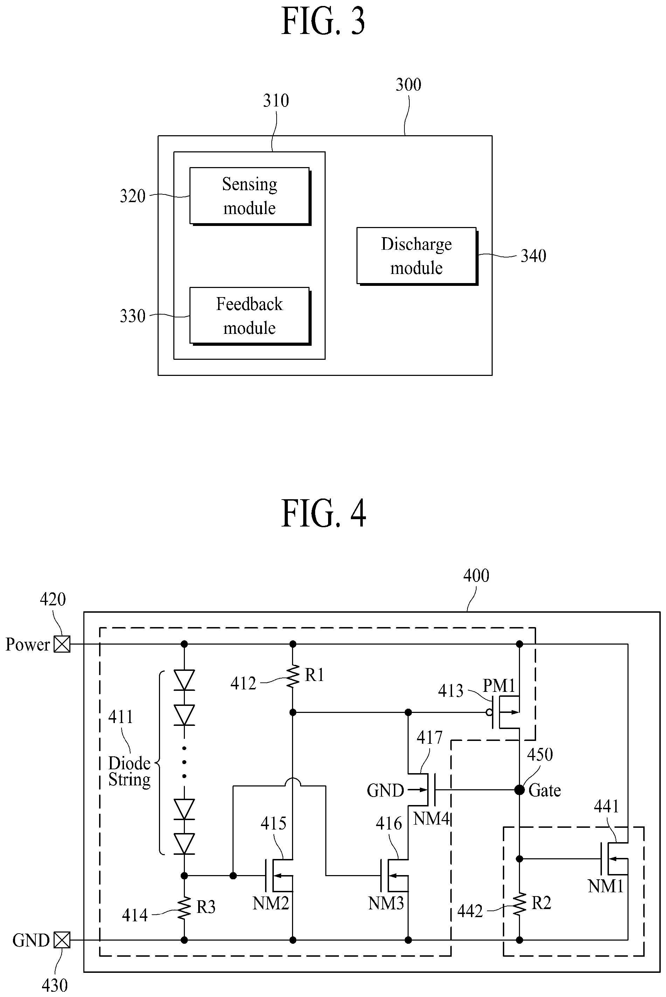

FIG. 3 is a block diagram schematically illustrating an EOS protection apparatus according to an embodiment of the present disclosure. To solve the problem of the related art described above, for example, a module performing a positive feedback function may be added to an embodiment of the present disclosure.

As illustrated in FIG. 3, an apparatus 300 for protecting EOS may include a discharge module 340 and a controller 310.

When a predetermined threshold voltage is sensed, the discharge module 340 may be designed to discharge EOS. Here, the predetermined threshold voltage may be a voltage which is applied by a power and turns on a sensing module 320 (for example, configured with at least one diode), and for example, may be proportional to the number of diodes, but the present disclosure is not limited thereto.

Moreover, the controller 310 may control the discharge module 340.

Particularly, the controller 310 may include the sensing module 320 which senses the predetermined threshold voltage and a feedback module 330 for increasing a response time of the discharge module 340 when sensing the predetermined threshold voltage.

It may be designed that after EOS is discharged, when less than the predetermined threshold voltage is formed, an operation of the feedback module 330 is deactivated.

The discharge module 340 and the controller 310, for example, may be connected to a specific gate. Furthermore, the feedback module 330 may be configured with a pair of at least one PMOS transistor and at least one NMOS transistor, which are disposed near the specific gate. Also, the feedback module 330 may perform a function of amplifying a voltage input to the NMOS transistor included in the discharge module 340. Herein, an example where a transistor such as an NMOS transistor or a PMOS transistor is used as a positive feedback (i.e., a circuit amplifying a signal) may be described, but the present disclosure is not limited thereto.

A more detailed circuit diagram associated with this will be described below in more detail with reference to FIG. 4.

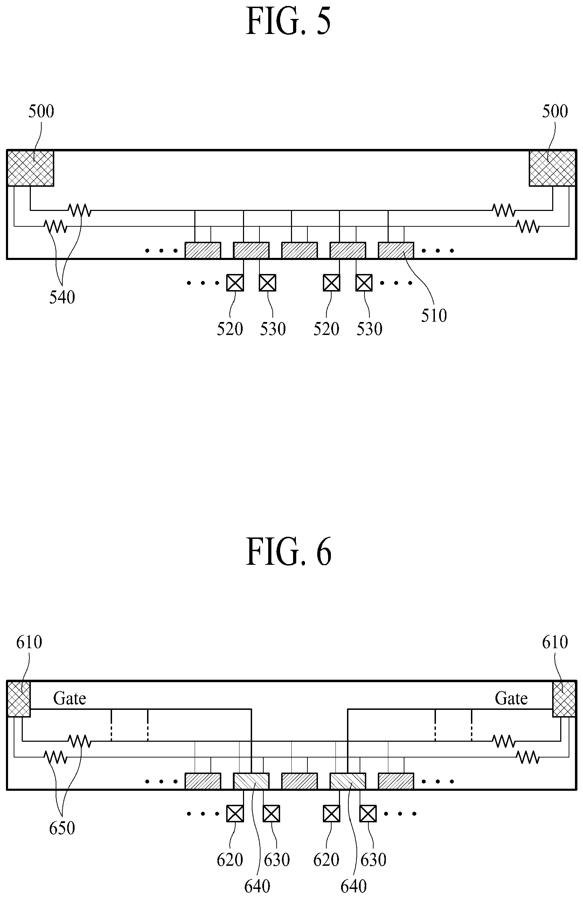

To solve another problem in terms of an arrangement view, it may be designed that the controller 310 is disposed on a side surface of a chip, and the discharge module 340 is disposed on a lower surface of the chip. An embodiment relevant thereto will be described below in more detail with reference to FIGs. 5 and 6.

FIG. 4 is a circuit diagram illustrating the block diagram of FIG. 3 in more detail.

As described above, for example, when an EOS design window is about 1.5 V and is narrow, a transistor for discharging should be fully turned on at almost the same time triggering in the EOS protection circuit.

To implement this, an apparatus 400 according to an embodiment of the present disclosure may additionally include elements 413 and 417 for a positive feedback function, and a more detailed operation process will be described below with reference to FIG. 4.

When a current occurs in a diode string 411 as a power 420 exceeds a normal range, a voltage may be formed in a third resistor (R3) 414, a transistor (NM2) 415 and a transistor (NM3) 416 may start to operate.

A current of the transistor (NM2) 415 causes voltage drop in a first resistor (R1) 412 and may operate a transistor (PM1) 413.

A transistor (NM4) 417 may start to operate, based on a current of the transistor (PM1) 413, and a current of the transistor (NM4) 417 may bias the transistor (PM1) 413 again, and thus, a signal may be amplified by a positive feedback operation, whereby a logical high signal may be applied to a gate 450 of a transistor (NM1) 441 for discharging EOS.

Therefore, the transistor (NM1) 441 may be fully turned on, and thus, it may be possible to more quickly discharge EOS. Furthermore, in FIG. 4, the NM1 441 which is an NMOS transistor is illustrated as an element performing an EOS discharge function, but an operation of allowing an EOS discharge function to be performed by using a PMOS transistor may be within another scope of the present disclosure. A second resistor 442 connected to the transistor (NM1) 441 may be connected to a ground 430.

Furthermore, when the power 420 again returns to a normal range after EOS is discharged, the transistor (NM3) 416 may be changed to an off state along with the transistor (NM2) 415, and a positive feedback operation based on two transistors 413 and 417 may end.

FIG. 5 illustrates an example of a case where an EOS protection circuit according to an embodiment of the present disclosure is disposed in an entire chip. Here, an entire chip illustrated in FIG. 5 may correspond to, for example, a DDI chip, but the present disclosure is not limited thereto.

The EOS protection circuit 300 illustrated in FIG. 3 or the EOS protection circuit 400 illustrated in FIG. 4, as illustrated in FIG. 5, may be disposed on each of a side surface 500 in an arrangement view of the entire chip.

Moreover, the EOS protection circuit disposed on the side surface 500 may be connected to a power 520 and a ground 530.

However, at least one rail resistor 540 may be disposed between the EOS protection circuit, the power 520, and the ground 530 disposed on the side surface 500. Also, the present disclosure may be applied to a case where there is no rail resistor 540, in addition to a case where the rail resistor 540 is provided.

For example, because a size of a chip is insufficient, in a case where it is unable to place an ESD power clamp circuit, a controller, and a module for discharging EOS together in a power pad, only the module for discharging EOS may be disposed in the power pad, and the controller may be disposed in another region.

That is, the controller and the module for discharging EOS may be spaced apart from each other, and the power pad may be disposed near the module for discharging EOS. For example, a design implemented so that a second distance between the module for discharging EOS and the power pad is shorter than a first distance between the controller and the power pad may be within the scope of the present disclosure.

Moreover, the rail resistor 540 described above may correspond to about 0.5 amperes to several amperes. Therefore, for example, when an EOS design window is about 1.5 V and is narrow, a transistor for discharging may not be fully turned on at almost the same time triggering in the EOS protection circuit.

An embodiment for solving such a special situation will be described below with reference to FIG. 6.

FIG. 6 illustrates another example of a case where an EOS protection circuit according to an embodiment of the present disclosure is disposed in an entire chip.

As described above, for example, when an EOS design window is about 1.5 V and is narrow, it may be needed to divide the EOS protection circuit into a controller and a discharge module and re-arrange the EOS protection circuit, so as to minimize an influence of an increase in voltage caused by a rail resistor.

A discharge module 640 for discharging EOS may be disposed at a lower end of a chip where a power pad 620 and a ground 630 are disposed, and a controller 610 for controlling the discharge module 640 may be disposed on a side surface of the chip.

Accordingly, according to a design diagram illustrated in FIG. 6, an influence caused by the rail resistor 650 may be removed, and there may be an additional technical effect where the discharge module 640 is possible to more quickly discharge EOS.

Furthermore, according to another embodiment of the present disclosure, in order to decrease an influence caused by the rail resistor, a process of placing all of the module 640 for discharging EOS and the controller 610 at the same position (for example, the power pad or the like) may be within the scope of the present disclosure.

On the other hand, because an ESD power clamp circuit should be installed at a position of the power pad, technology for separately separating and installing the module 640 for discharging EOS and the controller 610 may be needed. For example, in an arbitrary DDI chip, it may be assumed that the same ten power pads are distributed in a chip, and an EOS discharge module where a total width is 10 mm is needed.

In this case, EOS may be distributed and applied to ten power pads, and in this case, when all of a module for discharging EOS and a controller are disposed in a first power pad, rail resistors up to a corresponding position may appear in the other nine power pads.

On the other hand, as illustrated in FIG. 6, when a module for discharging EOS is split by 1 mm and is distributed and disposed in ten power pads for example, a technical effect for removing a rail resistor in all power pads may be realized.

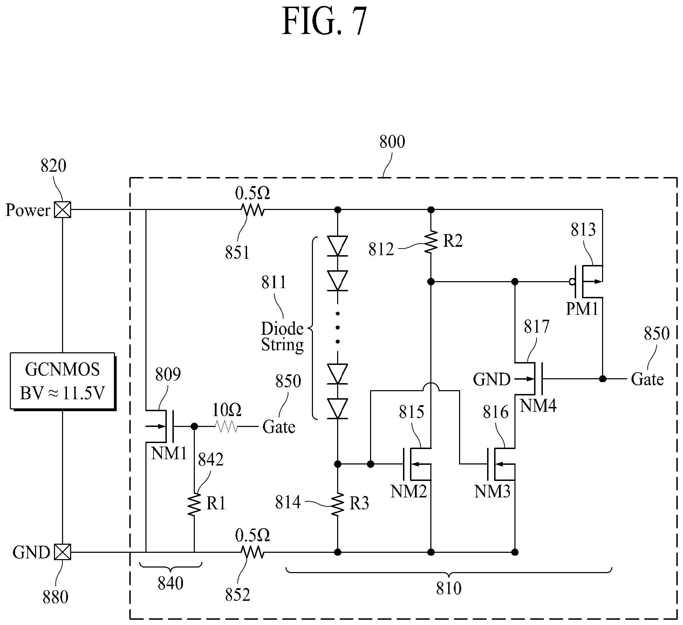

FIG. 7 is a circuit diagram illustrating the block diagram of FIG. 6 in more detail. FIG. 7, unlike FIG. 4, illustrates up to at least one rail resistor disposed between a power and a ground.

When a current occurs in a diode string 811 as a power 820 exceeds a normal range, a voltage may be formed in a third resistor (R3) 814, a transistor (NM2) 815 and a transistor (NM3) 816 may start to operate.

A current of the transistor (NM2) 815 causes voltage drop in a second resistor (R2) 812 and may operate a transistor (PM1) 813.

A transistor (NM4) 817 may start to operate, based on a current of the transistor (PM1) 813, and a current of the transistor (NM4) 817 may bias the transistor (PM1) 813 again, and thus, a signal may be amplified by a positive feedback operation, whereby a logical high signal may be applied to a gate 850 of a transistor (NM1) 809 for discharging EOS.

Therefore, the transistor (NM1) 809 may be fully turned on, and thus, it may be possible to more quickly discharge EOS. A first resistor 842 connected to the transistor (NM1) 809 may be connected to a ground 880.

Particularly, unlike FIG. 4, in FIG. 7, the transistor (NM1) 809 for discharging EOS may not be affected by rail resistors 851 and 852 and may be immediately grounded, and thus, there may be a technical effect where turn-on is more quickly performed.

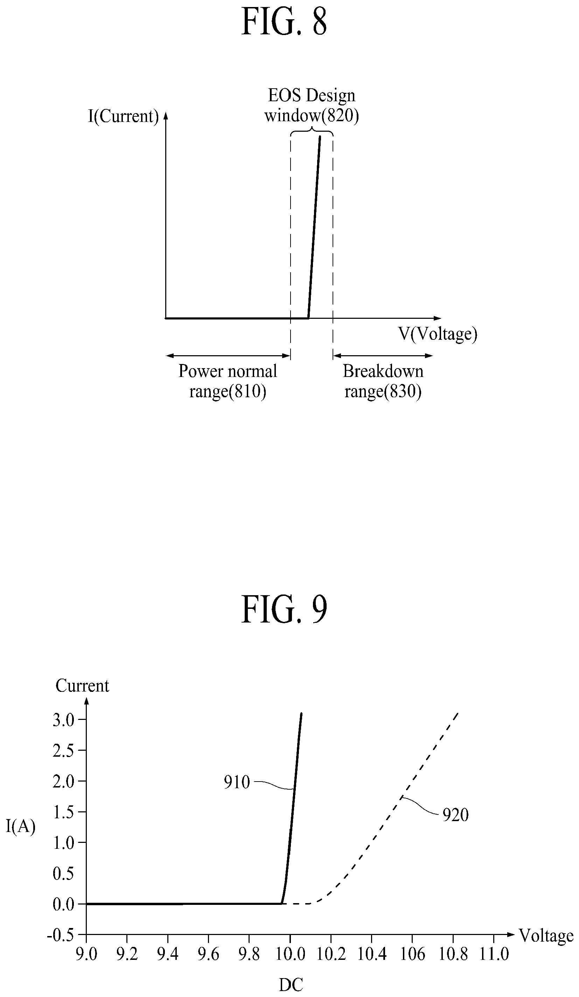

FIG. 8 is a graph illustrating variations of a current and a voltage based on an EOS protection circuit according to an embodiment of the present disclosure.

Unlike the related art, in order to fully turn on a transistor for discharging EOS, it may not be needed that a voltage difference between a power and a ground is sufficiently large.

As illustrated in FIG. 8, when a normal voltage range 810 is 10 V, and a breakdown voltage range 830 is 11.5 V, an EOS discharge transistor may be quickly switched on in a narrow interval (11.5V-10V=1.5V), and thus, a technical effect for removing all EOS may be obtained.

Furthermore, the present disclosure may be applied to a product where a normal range of a power corresponds to 0 V to 9.48 V for example, and a breakdown range of the power is greater than 11.5 V for example. To prevent an abnormal operation of a transistor for discharging EOS, a process which sets a margin of 0.52 V and turns on a transistor for discharging EOS when a power increases by 10 V or more may be within the scope of the present disclosure.

FIG. 9 is a graph of an experiment result for describing a comparison of the related art and an embodiment of the present disclosure.

As illustrated in FIG. 9, a curve 920 of the related art may have a problem where a current increases gently to reach a minimum voltage of a breakdown range, based on a direction current (DC) voltage of a power applied to an EOS protection circuit.

On the other hand, in a curve 910 according to an embodiment of the present disclosure, a technical effect has been experimentally confirmed where a current steeply increases when sensing a threshold voltage, and thus, the curve 910 does not reach the minimum voltage of the breakdown range.

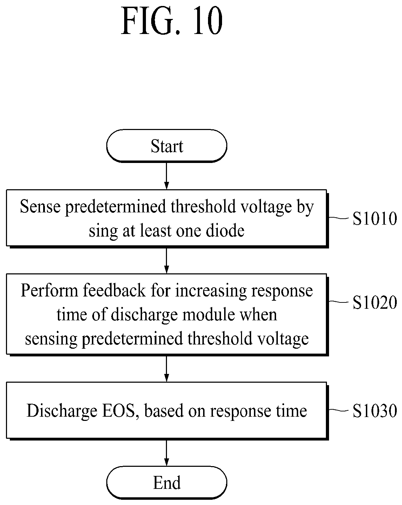

Moreover, FIG. 10 is a flowchart illustrating a method of controlling an EOS protection apparatus according to an embodiment of the present disclosure. Those skilled in the art may complementally analyze FIG. 10 with reference to the preceding drawings.

According to an embodiment of the present disclosure, an apparatus for protecting EOS may sense a predetermined threshold voltage by using at least one diode in step S1010.

Furthermore, the apparatus for protecting EOS may perform a feedback for increasing a response time of a discharge module when sensing the predetermined threshold voltage in step S1020, and moreover, may discharge EOS, based on the response time in step S1030.

Although not shown in FIG. 10, step S1020 may be designed so that a pair of at least one PMOS transistor and at least one NMOS transistor amplify a voltage input to a discharge module.

After step S1030, namely, after discharging EOS, the apparatus for protecting EOS according to an embodiment of the present disclosure may determine whether is less than the predetermined threshold voltage.

When it is determined to be less than the predetermined threshold voltage after the EOS is discharged as a result of the determination, the apparatus for protecting EOS according to an embodiment of the present disclosure may change step S1020 to an inactive state.

Moreover, when a difference between a maximum value of a normal range of a power supplied to the apparatus for protecting EOS according to an embodiment of the present disclosure and a minimum value of a breakdown range is small (for example, when equal to or less than 1.5 V), the apparatus may be more effective.

Furthermore, in a case where a DDI process is more subdivided, and based thereon, an ESD device characteristic is degraded or an EOS spec where it is difficult to manage with only an ESD apparatus is needed, a separate EOS protection circuit may be needed particularly.

Recently, corresponding needs for small DDI products are increasing. This may be because small DDI products have a trend where an EOS design window very narrows as a process is subdivided (40nm → 28nm).

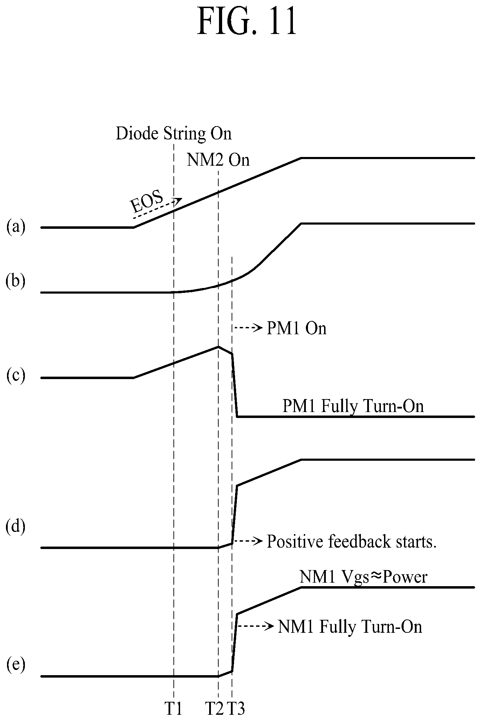

FIG. 11 illustrates operations of elements in a time sequence in the circuit diagram illustrated in FIG. 4.

First, it may be assumed that the X axis (abscissa axis) of FIG. 11 denotes a time T, and the Y axis (ordinate axis) denotes a voltage V.

FIG. 11 (a) illustrates that a voltage of EOS or more is applied through the power 420 illustrated in FIG. 4.

At a first time T1 at which the predetermined threshold voltage or more is sensed through a sensing module such as a diode, as illustrated in FIG. 11 (b), a voltage may start to be applied to gates of the transistor (NM2) 415 and the transistor (NM3) 416.

Moreover, at a second time T2, the transistor (NM2) 415 may be changed to a turn-on state, and as illustrated in FIG. 11 (c), the transistor (PM1) 413 may be changed to a turn-on state at a third time T3.

As described above with reference to FIG. 4, the transistor (NM4) 417 may start to operate, based on a current of the transistor (PM1) 413, and a current of the transistor (NM4) 417 may bias the transistor (PM1) 413 again. Accordingly, as illustrated in FIG. 11 (d), a signal may be amplified by a positive feedback operation for a short time from the third time T3.

Moreover, finally, as illustrated in FIG. 11 (e), the transistor (NM1) 441 may be fully turned on, and thus, it may be possible to more quickly discharge EOS.

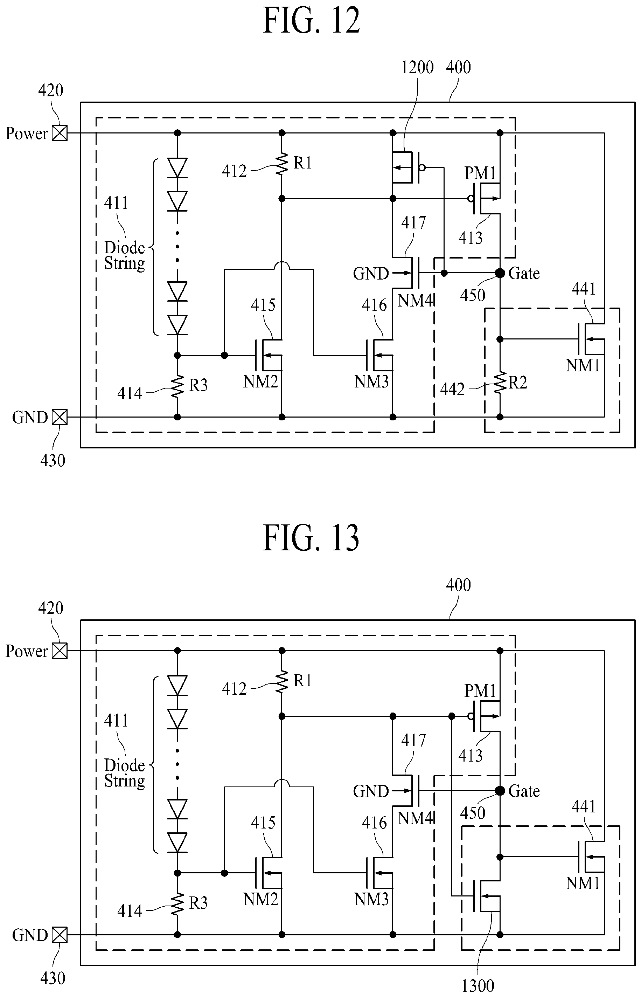

FIGs. 12 to 14 illustrate another embodiment for implementing the feedback module illustrated in FIG. 4. Like reference numerals refer to like elements, and thus, their repeated descriptions may be omitted.

FIG. 12 is similar to the circuit diagram illustrated in FIG. 4, and to implement a positive feedback function, a PMOS transistor 1200 serially connected to a transistor (NM4) 417 which is an NMOS transistor may be added.

FIG. 13 is similar to the circuit diagram illustrated in FIG. 4, and to implement the positive feedback function, an NMOS transistor 1300 serially connected to a transistor (PM1) 413 which is a PMOS transistor may be added.

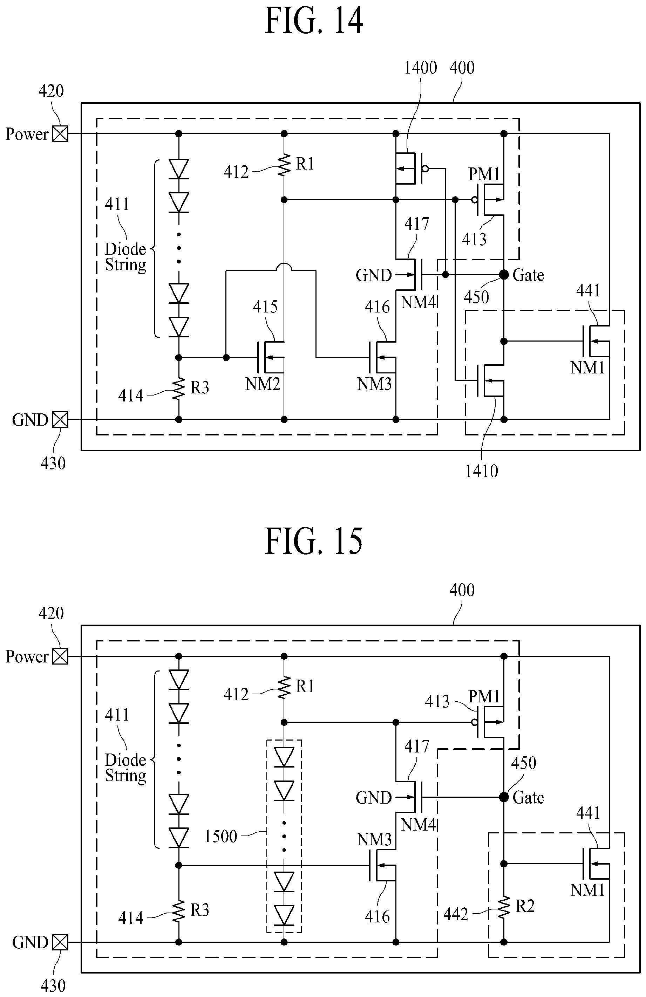

Moreover, FIG. 14 is similar to the circuit diagram illustrated in FIG. 4, and to implement the positive feedback function, a PMOS transistor 1400 serially connected to a transistor (NM4) 417 which is an NMOS transistor may be added, and an NMOS transistor 1410 serially connected to a transistor (PM1) 413 which is a PMOS transistor may be added.

Moreover, FIG. 15 illustrates another embodiment for implementing a sensing module illustrated in FIG. 4. Like reference numerals refer to like elements, and thus, their repeated descriptions may be omitted.

FIG. 15 is similar to the circuit diagram illustrated in FIG. 4, and a sensing module 1500 for sensing whether an EOS voltage is higher than or equal to a predetermined threshold voltage may be added in parallel with a conventional diode string 411.

The above-described feature, structure, and effect of the present disclosure are included in at least one embodiment of the present disclosure, but are not limited to only one embodiment. Furthermore, the feature, structure, and effect described in at least one embodiment of the present disclosure may be implemented through combination or modification of other embodiments by those skilled in the art. Therefore, content associated with the combination and modification should be construed as being within the scope of the present disclosure.

It will be apparent to those skilled in the art that various modifications and variations can be made in the present disclosure without departing from the spirit or scope of the disclosures. Thus, it is intended that the present disclosure covers the modifications and variations of this disclosure provided they come within the scope of the appended claims and their equivalents.

## Claims

1. An apparatus for protecting electrical over stress (EOS), the apparatus comprising:
a discharge module configured to discharge EOS when a predetermined threshold voltage is sensed; and
a controller configured to control the discharge module,
wherein the controller comprises:
at least one sensing module configured to sense the predetermined threshold voltage; and
a feedback module configured to increase a response time of the discharge module when sensing the predetermined threshold voltage.

2. The apparatus of claim 1, wherein the discharge module and the controller are connected to a specific gate.

3. The apparatus of claim 2, wherein the feedback module is configured with a pair of at least one P-channel metal-oxide-semiconductor (PMOS) transistor and at least one N-channel metal-oxide-semiconductor (NMOS) transistor disposed near the specific gate.

4. The apparatus of claim 3, wherein the feedback module amplifies a voltage input to the NMOS transistor included in the discharge module.

5. The apparatus of any one of the preceding claims, wherein the controller and the discharge module are spaced apart from each other.

6. The apparatus of any one of the preceding claims, wherein a power pad is disposed near the discharge module.

7. The apparatus of claim 6, wherein a second distance between the discharge module and the power pad is shorter than a first distance between the controller and the power pad.

8. The apparatus of any one of the preceding claims, wherein, after the EOS is discharged, when less than the predetermined threshold voltage is formed, an operation of the feedback module is deactivated.

9. The apparatus of any one of the preceding claims, wherein a difference between a maximum value of a normal range of a power supplied to the apparatus and a minimum value of a breakdown range is 1.5 V or less.

10. A method for controlling an apparatus for protecting electrical over stress (EOS), the method comprising:
a step of sensing a predetermined threshold voltage by using at least one sensing module;
a feedback step of increasing a response time of a discharge module when sensing the predetermined threshold voltage; and
a step of discharging EOS, based on the response time.

11. The method of claim 10, wherein the feedback step comprises a step of amplifying a voltage input to the discharge module by using a pair of at least one P-channel metal-oxide-semiconductor (PMOS) transistor and at least one N-channel metal-oxide-semiconductor (NMOS) transistor.

12. The method of claim 10 or 11, further comprising a step of determining whether is less than the predetermined threshold voltage, after the EOS is discharged.

13. The method of claim 11 or 12, further comprising,
after the EOS is discharged, when it is determined to be less than the predetermined threshold voltage as a result of the determination,
a step of deactivating the feedback step.

14. The method of any one of claims 10 to 13, wherein a difference between a maximum value of a normal range of a power supplied to the apparatus and a minimum value of a breakdown range is 1.5 V or less.

15. The method of any one of claims 10 to 14, wherein the apparatus comprises a display driver integrated circuit (DDI).
